# EUROPEAN PATENT SPECIFICATION

(11) **EP 2 001 603 B1**
(45) Date of publication and mention of the grant of the patent: **26.09.2012**
(21) Application number: 07751838.9
(22) Date of filing: 27.02.2007
(51) Int. Cl.: B05D 7/14, B41M 5/00, H05K 3/06, C23F 1/18

(54) **PROCESS FOR CREATING A PATTERN ON A COPPER SURFACE**
VERFAHREN ZUR STRUKTURERZEUGUNG AUF EINER KUPFEROBERFLÄCHE
PROCÉDÉ DE CRÉATION D'UN MOTIF SUR UNE SURFACE DE CUIVRE

(30) Priority: 05.04.2006 US 398080
(43) Date of publication of application: 17.12.2008
(73) Proprietor: MacDermid, Incorporated, Waterbury, CT 06702 (US)
(72) Inventor: SAWOSKA, David, Woodlands, Texas 77389 (US); KROL, Andrew, M., Bristol, CT 06010 (US); CASTALDI, Steven, A., Torrington, CT 06790 (US)
(74) Representative: Jenkins, Peter David
(86) International application number: PCT/US2007/005105
(87) International publication number: WO 2007/126516

(56) References cited:
- GB-A- 2 350 321
- SU-A- 1 281 590
- US-A- 4 594 111
- US-A- 5 958 647
- US-A1- 2003 177 639
- US-A1- 2006 060 563
- US-B2- 6 872 321

## Description

### BACKGROUND OF THE INVENTION

The present invention relates to a process of forming an image or pattern on the surface of copper or copper alloys. Specifically the invention relates to forming such patterns using a droplet discharge technique upon a copper or copper alloy surface that has been treated to improve the resolution of the droplet discharge technique. The present process is particularly suited to the formation of printed circuits.

Droplet discharge techniques typified by a piezo method, thermal jet method, or a continuous droplet discharge technique, have been widely known for general printing and image.creation for a long time. However, application of these techniques to the imaging of printed circuits or semi-conductors is much more recent. Recent attempts in this regard are described in U.S. 6,861,377 and U.S. 2005/0095356 A1.

Using droplet discharge techniques for the formation of circuit features requires very fine resolution with some resolution goals reaching into the micron or submicron range. These resolution goals have been difficult to meet with the current droplet discharge techniques and equipment. Thus substantial effort has been expended to improve the resolution of these techniques, particularly on the copper surfaces necessary for the formation of electronic circuits.

A variety of variables are known to affect the resolution of droplet discharge techniques including: print head design, droplet size, software driving the print head, closeness of the print head to the surface being printed upon, and the properties of the liquid being printed. Each of the foregoing factors has been studied in an attempt to maximize resolution. However, resolution goals in forming electronic circuits using these techniques have remained unsatisfied.

US2003/177639 discloses a method and apparatus for producing printed circuits utilizing direct printing methods to apply a pattern mask to a substrate. The pattern mask may be an etch resist mask or a plating mask.

It is an object of this invention to propose a process that improves the resolution of droplet discharge techniques when printing on copper or copper alloy surfaces.

### SUMMARY OF THE INVENTION

The inventors herein have discovered that if the surface of the copper or copper alloy is preferably microetched and then treated with an organic substance capable of lowering the surface energy of the copper surface or capable of making the copper surface more hydrophobic prior to being printed upon, the resolution of the subsequent printing is improved. Thus a process for printing upon a surface comprising copper is disclosed, such process comprising:
1. optionally, but preferably, contacting the surface with a microetchant;
2. contacting the surface with an aqueous solution of an organic substance capable of lowering the surface energy of the copper surface or capable of making the copper surface more hydrophobic; and
3. printing upon the surface with a droplet discharge mechanism.

### DETAILED DESCRIPTION OF THE INVENTION

The invention comprises a process for printing upon a surface comprising copper, said process comprising:
1. optionally, but preferably, contacting the surface with a microetchant;
2. contacting the surface with an aqueous solution of an organic substance capable of lowering the surface energy of the copper surface or capable of making the copper surface more hydrophobic; and then
3. using a droplet discharge mechanism to create an image on the surface by printing an ink or organic resist onto the surface.

Typically the copper or copper alloy surfaces used in this invention comprise a copper clad laminate used in the production of printed circuit boards. These laminates usually have a cured core of epoxy, polyamide or other similar resin (sometimes reinforced by glass fibers) with cropper foil laminated to opposite sides of the core. Such copper clad laminates are widely known for use in the manufacture of printed circuits. The laminates may be rigid or flexible.

Optionally, but preferably, the copper surfaces are microetched to roughen the surface on a micro-scale. Microetches in general are well known in the printed circuit field. Typical microetches useful in this invention include aqueous solutions of hydrogen peroxide and sulfuric acid or aqueous solutions of sodium or ammonium persulfate with sulfuric acid. Typical concentrations in the microetch are (i) hydrogen peroxide at 10-100 g/l, (ii) sodium persulfate at 25-250 g/l and (iii) sulfuric acid at 50-250 g/l. Other known microetches may also be used.

In accordance with this invention the copper surfaces are contacted with an aqueous solution of an organic substance capable of lowering the surface energy of the copper surface or capable of making the copper surface more hydrophobic. The organic substance may preferably be selected from the group consisting of fatty acids, resinous acids and mixtures thereof. Preferred fatty acids include tall oil. Preferred resinous acid include acids obtained from pine resin such as abietic acid. These fatty acids and/or resinous acids are dissolved in water and the solution is used to coat the copper surfaces prior to printing. The organic surface is dissolved in water, preferably, at a concentration from 0.05 to 2.0 g/l. The pH of the aqueous solution of the organic substance is adjusted to preferably from 7 to 14. More than one organic substance may be included in the solution. Organic solvents and organic or inorganic alkali and acids may also be added to the aqueous solution.

The copper surfaces can be contacted with the aqueous solution of the organic substance by immersion, spray or flood. Preferably the contact time is from 15 to 30 seconds. The contact temperature is preferably from room temperature to 77°C. Once the surface is contacted with the organic substance it is preferably rinsed in deionized water and dried with forced air. At this point the surface is ready to be printed upon.

The printing method used is a droplet discharge technique such as piezo printing, thermal jet printing or continuous droplet discharge. These methods are sometimes collectively referred to as ink jet printing. For a discussion of these various printing techniques the reader is referred to U.S. Patent Nos. 6,715,871 and 6,754,551. Reference is also made to published U.S. Patent Application Nos. U.S. 2005/0003645 A1 and U.S. 2005/0112906 A1.

The inventors herein have preferred the piezo printing technique and this regard have utilized a MacDermid Colorspan, Inc. printer, model Display Maker 72 UVR. The print heads used in the foregoing model are piezo ink jet heads with the following specifications: Ricoh Gen 3E1M96 Channel 30 pL drop volume operating up to 80°C and 20 KHZ with 600 DPI nominal resolution.

The ink jet printer can be used to print inks or organic resists onto the surfaces. The inks or organic resists may be of the type that are heat or convection cured or may be photosensitive and cured using actinic radiation such as ultraviolet light. The inventors herein prefer ultra violet light curable organic resists. In any case, the ink or organic resist to be printed preferably has a viscosity between 0.005 and 0.015 Pa·s at operating temperature.

The inventors herein have preferred to print with an organic resist comprising a oligomers, monomer(s), and a photoinitiator.

Typical oligomers include urethane acrylates, polyester acrylates, epoxy acrylates and acidic acrylates.

Typical monomers include momo and multi functional acrylates such as isobornyl acrylate, tripropylene glycol diacrylate, ethoxylated trimethylolpropene triacrylate, and acid esters.

Useful photoinitiators include acetophenones such as 2-benzyl-2-2(dimethylamino) -1-4-(A-morpholinyl) phenyl-1-butanone, 2-dimethoxy-2-phenyl acetophenone, thioxanthones such as isopropyl thioxanthone, and ketals such as benzyl dimethyl ketone. Typical photosensitive organic resist compositions are disclosed in U.S. Patent Nos. 6,322,952; 6,475,702 and 6,136,507, the teachings each of which are incorporated herein in their entirety. If a photosensitive organic resist is used, typically a source of actinic radiation, such as ultra violet light, is preferably attached to the carriage which holds the print head such that the curing process occurs shortly after the droplets are printed.

The inventors believe that treatment of the copper surfaces with the process of this invention prior to printing modifies the surface properties of the copper surfaces such that retention of the droplets on the surface with less spreading is enhanced and therefore resolution is enhanced.

The following example is meant to be illustrative but not limiting:

### EXAMPLE 1

Two pieces of copper clad laminate were taken. One piece was printed upon directly in a line and space pattern using a MacDermid Colorspan model Display Maker 72 UVR printer and an organic photosensitive resist comprising:

| **Component** | **Weight Percent** |
|---|---|
| Genomer 1122① | 17.39 |
| Sartomer SR454② | 10.43 |
| Sartomer SR306② | 17.43 |
| Sartomer SR506② | 20.83 |
| Sartomer CD9050② | 9.57 |
| Sartomer CN147② | 13.51 |
| Irgacure 369③ | 1.74 |
| Irgacure 907③ | 6.96 |
| Speedcure ITX④ | 1.74 |
| Crystal Violet dye | 0.40 |

| | |
|---|---|
| 1. Available from Rahn USA Corp. 2. Available from Sartomer Company 3. Available from Ciba-Geigy Company 4. Available from Aceto Chemical Corp. | |

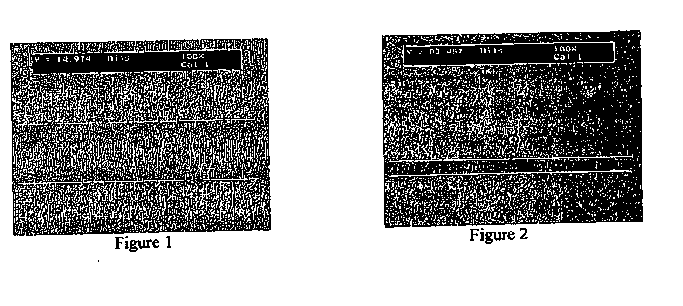

Resolution was determined via microscopic visual examination to be approximately 15 mils. Figure 1 is a photomicrograph of the printed line on the first copper surface.

The second piece of copper clad laminate was first treated in the following process before being printed upon in the same manner with the same equipment and organic resist as the first piece:
1. Microetch in an aqueous solution of 25 g/l hydrogen peroxide and 100 g/l sulfuric acid at 32 °C for 2 minutes.
2. Rinse is deionized water.
3. Immerse in an aqueous solution of 0.5 g/l tall oil at a pH of 12.
4. Rinse is deionized water.
5. Forced air dry.

Resolution was determined via microscopic visual examination to be approximately 0.076 mm Figure 2 is a photomicrograph of the printed line on the second copper surface.

## Claims

1. A process for printing upon a surface comprising copper, said process comprising:
a. contacting the surface with an aqueous solution comprising an organic substance selected from the group consisting of fatty acids, resinous acids and mixtures of the foregoing, and then
b. printing an ink or an organic resist onto the surface using a droplet discharge mechanism.

2. A process according to claim 1 wherein the organic substance comprises tall oil.

3. A process according to claim 1 wherein the ink or organic resist comprises a photosensitive organic resist.

4. A process according to claim 3 wherein the organic resist has a viscosity from 0.005 to 0.015 Pa·s.

5. A process according to any one of claims 1, 2, 3, or 4 wherein the surface is contacted with a microetchant before being contacted with an aqueous solution of an organic anti-tarnish.

6. A process according to any one of claims 1, 2, 3 or 4 wherein the droplet discharge mechanism comprises a print head mounted on a movable carriage and wherein the print head is selected from the group consisting of piezo print heads, thermal jet print heads, and continuous droplet discharge print heads.

7. A process according to claim 6 wherein a source of actinic radiation is also mounted on the movable carriage.

## Patentansprüche

1. Verfahren zum Drucken auf einer Oberfläche, die Kupfer aufweist, wobei das Verfahren aufweist:
a. Kontaktieren der Oberfläche mit einer wässrigen Lösung, die eine organische Substanz aufweist, die aus der Gruppe bestehend aus Fettsäuren, harzhaltige Säuren und Mischungen hiervon ausgewählt ist, und dann
b. Drucken einer Tinte oder einer organischen Schicht auf die Oberfläche unter Verwendung einer Tropfen-Entladungs-Einrichtung.

2. Verfahren nach Anspruch 1, wobei die organische Substanz Tallöl aufweist.

3. Verfahren nach Anspruch 1, wobei die Tinte oder die organische Schicht eine lichtempfindliche organische Schicht aufweist.

4. Verfahren nach Anspruch 3, wobei die organische Schicht eine Viskosität von 0,005 bis 0,015 Pa·s hat.

5. Verfahren nach einem der Ansprüche 1, 2, 3 oder 4, wobei die Oberfläche mit einem Mikro-Ätzmittel kontaktiert wird, bevor sie mit einer wässrigen Lösung eines organischen Korrosionsschutzes kontaktiert wird.

6. Verfahren nach einem der Ansprüche 1, 2, 3 oder 4, wobei die Tropfen-Entladungs-Einrichtung einen Druckkopf aufweist, der an einem beweglichen Schlitten montiert ist und wobei der Druckkopf aus der Gruppe bestehend aus Piezo-Druckköpfen, thermischen Düsen-Druckköpfen und Dauer-Tropfen-Entladungs-Druckköpfen ausgewählt ist.

7. Verfahren nach Anspruch 6, wobei eine Quelle für photochemische Strahlung ebenfalls an dem beweglichen Schlitten montiert ist.

## Revendications

1. Procédé pour imprimer sur une surface comprenant du cuivre, le procédé comprenant les étapes suivantes :
a. mettre la surface en contact avec une solution aqueuse comprenant une substance organique sélectionnée dans le groupe comprenant les acides gras, les acides résineux et leurs mélanges, puis
b. imprimer une encre ou un matériau d'épargne organique sur la surface en utilisant un mécanisme d'émission de gouttelettes.

2. Procédé selon la revendication 1, dans lequel la substance organique comprend du tallöl.

3. Procédé selon la revendication 1, dans lequel l'encre ou le matériau d'épargne organique comprend un matériau d'épargne organique photosensible.

4. Procédé selon la revendication 3, dans lequel le matériau d'épargne organique a une viscosité comprise entre 0,005 et 0,015 Pa·s.

5. Procédé selon l'une quelconque des revendications 1, 2, 3 ou 4, dans lequel la surface est mise en contact avec un micro-gravant avant d'être mise en contact avec une solution aqueuse d'un agent anti-ternissure organique.

6. Procédé selon l'une quelconque des revendications 1, 2, 3 ou 4, dans lequel le mécanisme d'émission de gouttelettes comprend une tête d'impression montée sur un chariot mobile et dans lequel la tête d'impression est sélectionnée dans le groupe comprenant les têtes d'impression piézo, les têtes d'impression à jet thermique, et les têtes d'impression à émission continue de gouttelettes.

7. Procédé selon la revendication 6, dans lequel une source de rayonnement actinique est aussi montée sur le chariot mobile.
